(19)

**Europäisches Patentamt**
**European Patent Office**
**Office européen des brevets**

(11) **EP 1 529 193 B1**

(12) **EUROPEAN PATENT SPECIFICATION**

(45) Date of publication and mention
of the grant of the patent:
**07.10.2009 Bulletin 2009/41**

(51) Int Cl.:
*G01B 11/06* (2006.01)     *H01L 21/334* (2006.01)
*H01L 21/8242* (2006.01)

(21) Application number: **03785204.3**

(22) Date of filing: **12.08.2003**

(86) International application number:
**PCT/US2003/025156**

(87) International publication number:
**WO 2004/015727 (19.02.2004 Gazette 2004/08)**

(54) **METHOD FOR CONTROLLING A RECESS ETCH PROCESS**

VERFAHREN ZUR STEUERUNG EINES GRABENÄTZPROZESSES

METHODE PERMETTANT DE COMMANDER UN PROCEDE DE GRAVURE D'EVIDEMENTS

(84) Designated Contracting States:
**AT BE BG CH CY CZ DE DK EE ES FI FR GB GR
HU IE IT LI LU MC NL PT RO SE SI SK TR**

(30) Priority: **13.08.2002 US 403213 P
06.09.2002 US 408619 P
01.11.2002 US 286410
01.11.2002 US 286409
27.03.2003 US 401118**

(43) Date of publication of application:
**11.05.2005 Bulletin 2005/19**

(73) Proprietor: **LAM RESEARCH CORPORATION
Fremont, CA 94538 (US)**

(72) Inventors:
• **VENUGOPAL, Vijayakumar, C.**
**Berkeley, CA 94709 (US)**
• **PERRY, Andrew, J.**
**Fremont, CA 94536 (US)**

(74) Representative: **Browne, Robin Forsythe et al
Leaman Browne
5 South Parade
Leeds
LS1 5QX (GB)**

(56) References cited:
**EP-A- 1 111 356          US-A- 5 900 633
US-A1- 2002 090 743     US-B1- 6 275 297**

• **BOSCH-CHARPENAY S ET AL: "REAL-TIME
ETCH-DEPTH MEASUREMENTS OF MEMS
DEVICES" JOURNAL OF
MICROELECTROMECHANICAL SYSTEMS, IEEE
INC. NEW YORK, US, vol. 11, no. 2, April 2002
(2002-04), pages 111-117, XP001125204 ISSN:
1057-7157**
• **BENSON T E ET AL: "In-situ spectroscopic
reflectometry for polycrystalline silicon thin film
etch rate determination during reactive ion
etching" JOURNAL OF ELECTRONIC
MATERIALS, JUNE 1996, TMS, USA, vol. 25, no.
6, pages 955-964, XP001041266 ISSN: 0361-5235**
• **ANONYMOUS: "Zero-Order Reflecting Reference
Optics." IBM TECHNICAL DISCLOSURE
BULLETIN, vol. 32, no. 8B, 1 January 1990
(1990-01-01), pages 381-383, XP000082159 New
York, US**
• **PATENT ABSTRACTS OF JAPAN vol. 2000, no.
13, 5 February 2001 (2001-02-05) & JP 2000 292129
A (TOSHIBA CORP), 20 October 2000 (2000-10-20)**
• **HICKS S E ET AL: "REFLECTANCE MODELING
FOR IN SITU DRY ETCH MONITORING OF BULK
SIO2 AND III-V MULTILAYER STRUCTURES"
JOURNAL OF VACUUM SCIENCE AND
TECHNOLOGY: PART B, AMERICAN INSTITUTE
OF PHYSICS. NEW YORK, US, vol. 12, no. 6, 1
November 1994 (1994-11-01), pages 3306-3310,
XP000497155 ISSN: 0734-211X**

**Description**

BACKGROUND OF THE INVENTION

The invention relates generally to methods for monitoring and controlling processes used in forming features on patterned substrates, such as semiconductor substrates. More specifically, the invention relates to a method for detecting an endpoint in a recess etch process.

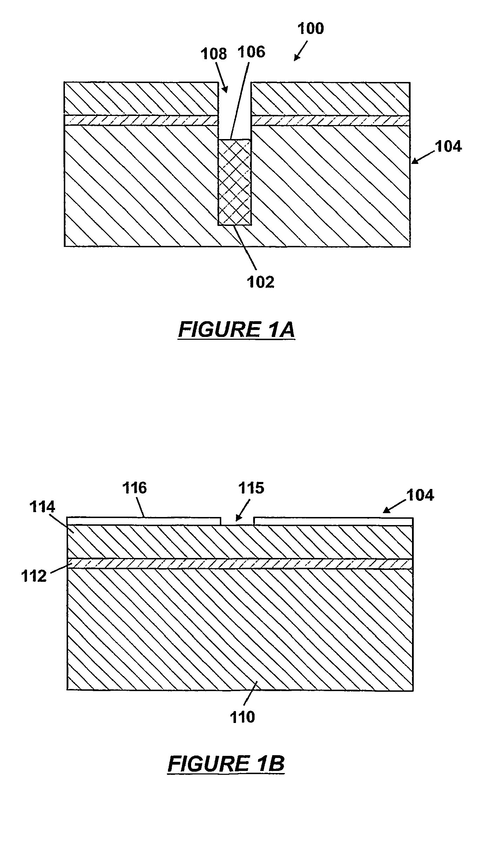

Recess etch processes are used in fabricating semiconductor devices such as dynamic random access memory (DRAM) and embedded DRAM (eDRAM). DRAMs and eDRAMs store information in integrated circuits that contain capacitors. Figure 1A shows a typical storage node 100 of a DRAM cell. The storage node 100 includes a deep trench 102 formed in a patterned semiconductor substrate 104. A column of polysilicon 106 is formed in the deep trench 102, and a recess 108 is provided above the column of polysilicon 106. The recess 108 may be lined with an insulation material (not shown) so as to isolate the polysilicon 106 from structures, such as transfer devices, above. The trench 102 typically has a high aspect ratio. In the current technology, for example, the depth of the trench 102 is typically several microns deep, while the width of the trench 102 is typically on the order of 300 nm. As advances are made in integration technology, the width of the trench is expected to get even smaller, e.g., shrink down to 90-100 nm.

Figure 1B shows the semiconductor substrate 104 prior to forming the deep trench (102 in Figure 1A). In a typical configuration, the semiconductor substrate 104 includes a substrate layer 110, typically made of silicon, a dielectric layer 112, typically made of silicon dioxide, and a mask layer 114, typically made of silicon nitride. The semiconductor substrate 104 is coated with a thin-film of photoresist mask 116. Before forming the trench, an area 115 of the photoresist mask 116 where the trench will be formed is removed, causing the underlying layers to become exposed. The semiconductor substrate 104 is then placed in a process chamber (not shown), such as a plasma chamber, and the trench is etched through the exposed underlying layers and into the substrate. After etching the trench, the remaining photoresist mask 116 is removed.

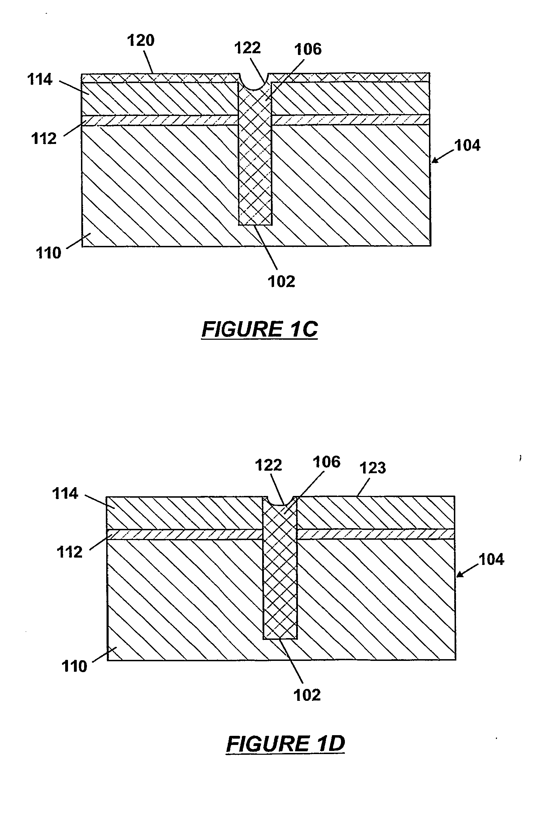

Figure 1C shows the semiconductor substrate 104 after etching the trench 102 and removing the photoresist mask (116 in Figure 1B). In the figure, the trench 102 is filled with polysilicon 106. As the trench 102 is filled with polysilicon, a blanket of polysilicon 120 is also formed on the top surface of the semiconductor substrate 104, *i.e.,* over the mask layer 114. Typically, a small dish (or depression) 122 also appears above the opening of the trench 102 as a consequence of the filling process. To facilitate etching of a recess in the column of polysilicon 106 in the trench 102, the blanket of polysilicon 120 is then removed (or planarized), as shown in Figure 1D. The planarized surface 123 can be produced by a process such as planar layer etching or chemical-mechanical polishing. It should be noted that all or only a portion of the blanket of polysilicon (120 in Figure 1C) may be removed during the planarization process. After planarizing the blanket of polysilicon, the column of polysilicon 106 in the trench 102 is etched down to a predetermined depth to form the recess (108 in Figure 1A).

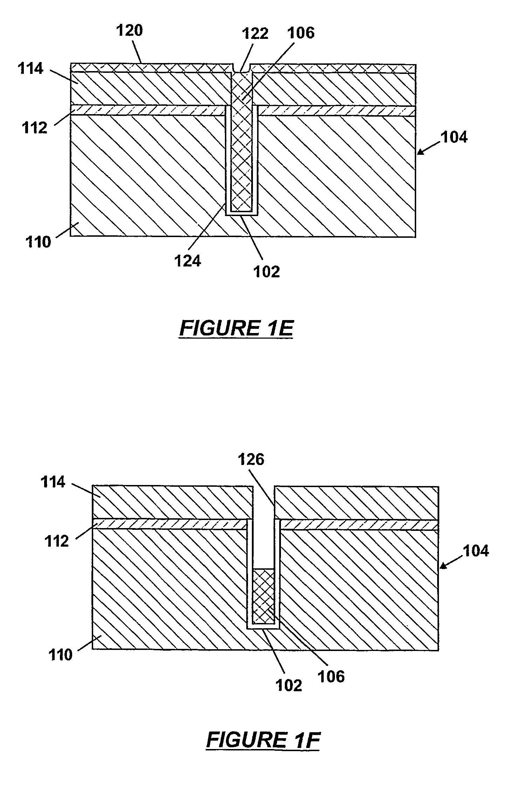

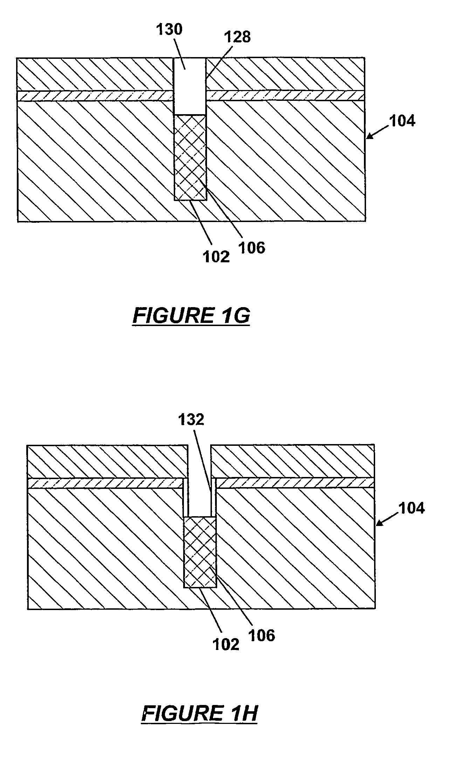

Various modifications can be made to the sequence of processes described above to form different recess structures. For example, as shown in Figure 1E, the trench 102 can be initially lined with a dielectric material 124, such as an oxide. Polysilicon 106 can then be deposited into the lined trench 102 and on top of the mask layer 114, as previously described. The blanket of polysilicon 120 on the mask layer 114 can be planarized, and the column of polysilicon 106 can be etched down to form a lined recess (126 in Figure 1F). This process may be used to create a buried polysilicon strap, for example. In another example, as shown in Figure 1G, the column of polysilicon 106 in the trench 102 can be etched to form a recess 128. The recess 128 can then be filled with a dielectric material 130, such as an oxide. Another etching process can be used to remove a portion of the dielectric material 130 so as to form a dielectric liner (132 in Figure 1H) that extends partly down the trench 102.

In most applications, the depth of the recess relative to a reference point in the semiconductor substrate, such as the bottom of the sacrificial mask layer, is a critical dimension. Thus, the ability to accurately determine how far down to etch the column of polysilicon in the trench to achieve the desired recess depth is very important. Various factors make it challenging to form a recess of a desired depth in the trench. For example, the opening of the trench through which the recess will be etched is very tiny, and the scale of the depression above the column of polysilicon in the trench can easily be on the same order as the accuracy or even the absolute depth of the recess to be etched. Perhaps even more challenging are the incoming material variations from one substrate to another, e.g., the variations in the thickness of the mask layer and the depth of the depression above the column of polysilicon in the trench. Without knowing these variations, it would be difficult to accurately determine how far down to etch the column of polysilicon to make the required recess dept.

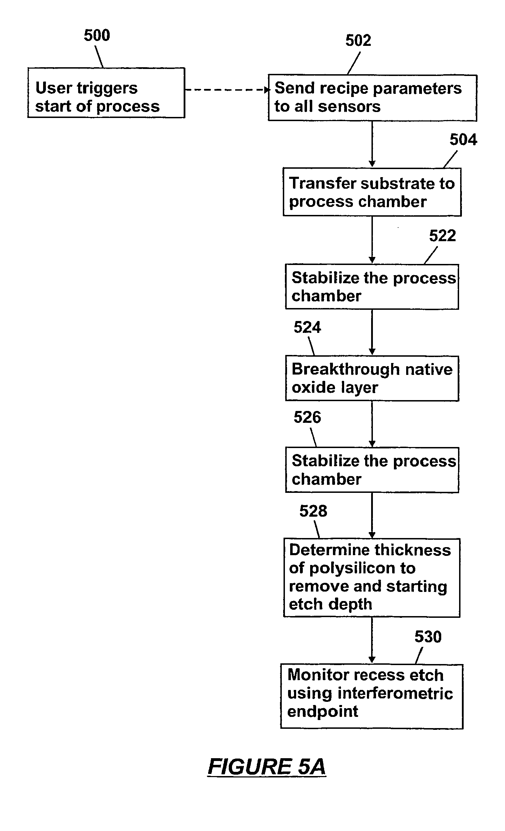

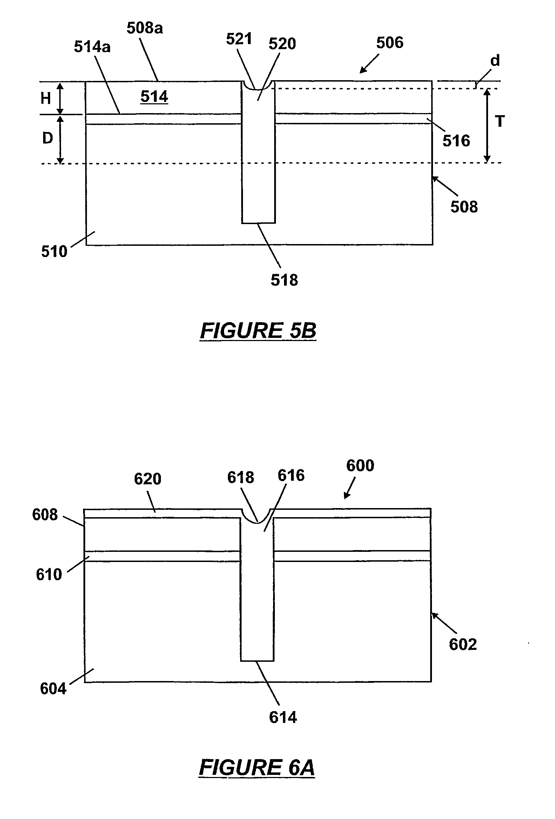

"REAL-TIME ETCH-DEPTH MEASUREMENTS OF MEMS DEVICES"; JOURNAL OF MICRO ELECTROMECHANICAL SYSTEMS, IEEE INC. NEW YORK, US; 2002-04-00; BOSCH-CHARPENAY S; Vol. 11; Nr. 2; pages 111-117 (pages 113-114; Fig. 5) discloses a method of in situ real-time process control for deep reactive-ion etch fabrication of MEMS structures which comprise 10 micron wide trenches (Fig. 1a) with depths in the range of 2-12 micron between which are unetched areas covered with a photo resist mask (which is subject to minimal erosion). The control process uses a FTIR spectrometer at an incidence angle of 4° and a full spectrum model for fitting parameters such as etch depth with a least-square minimum error algorithm. The preferred model is the "scalar diffraction model" which, "assumes that the patterned wafer is divided into separate uniform thin film regions each region having a specific film stack and for which the reflection coefficients can be calculated using standard multi-layer models" and in which "the total complex reflection coefficient is calculated as the weighted sum of the individual complex reflection coefficients for the different film stacks" according to equation 3. This SCALAR diffraction model, "does not account for light travelling from one film stack (region) into another" i.e. an incoherent sum is assumed. In the limit of the regions having a size comparable or smaller than the wavelengths used, a VECTOR diffraction model is required to obtain coupled wave solutions to account for interfering wavefronts from "laterally distinct areas" which are spaced apart by distances comparable to or less than a wavelength - i.e. a coherent sum of contributions from such "laterally distinct areas". Regions which are laterally spaced by greater than a wavelength can therefore be modelled adequately using a scalar (incoherent) sum whereas laterally distinct areas spaced less than a wavelength are modelled using a vector (coherent) sum. The depth of the trench etched with respect to the bare silicon surface (or the surface of the photo resist mask) is the first dimension which is compared to the desired recess depth to determine the endpoint. This document (page 116, section IV) also discloses that the above "scalar diffraction model" technique is applicable also to DRIE of SOI materials which involves etching of trenches which are filled with sacrificial materials.

US6275297 (Fig. 1-4; cols 4-7) discloses methods of measuring a depth geometry of a structure on a semiconductor substrate including a plurality of recessed and non-recessed portions e.g. for in-situ determination of the depth of a trench with a dielectric oxide layer filling the recess in a poly recess on oxide process in which the different lateral regions are modelled as multi layer stacks. The depth geometries are determined by fitting the detected broadband spectral reflectance to a model in which terms including Er2 which describes light reflected from the non-recessed portion and Et2 which describes light reflected from the filled recessed portions are summed (incoherently) together with an interference component ErxEt describing light reflected from both the recessed and non-recessed portions by weighting with parameters C1, C2, and C3. A processor 40 fits the a reflectance model to the measured reflectance intensity versus wavelength to determine parameters such as the depth of the recesses 12. US6275297 further discloses that the etch depth determinations are to be made in situ in the context of semiconductor device fabrication, in particular during poly recess on oxide processing.

What is desired therefore is a method for detecting an endpoint in a recess etch process by monitoring the absolute recess depth that takes into account such factors as incoming material variations.

SUMMARY OF THE INVENTION

The invention relates to a method of controlling a recess etch process as defined in the appended claims.

In another aspect a method of controlling a recess etch process is disclosed which comprises planarizing a surface of a multilayered substrate having a trench therein and a column of material deposited in the trench. This method further includes determining a first dimension from the surface of the substrate to a reference point in the substrate after planarizing. The first dimension is determined by obtaining a measured net reflectance spectrum of at least a portion of the substrate including the trench, computing a modeled net reflectance spectrum of the portion of the substrate as a weighted incoherent sum of reflectances from $n \geq 1$ different regions constituting the portion of the substrate, wherein the reflectance of each of the n different regions is a weighted coherent sum of reflected fields from $k \geq 1$ laterally-distinct areas constituting the region, determining a set of parameters that provides a close match between the measured net reflectance spectrum and the modeled net reflectance spectrum, and extracting the first dimension from the set of parameters. This method further includes computing an endpoint of the recess etch

process as a function of the first dimension and a desired recess depth measured from the reference point and etching down from a surface of the column of material until the endpoint is reached.

These and other features and advantages of the invention will be discussed in more detail in the following detailed description of the invention and in conjunction with the following figures.

BRIEF DESCRIPTION OF THE DRAWINGS

The invention is illustrated by way of example, and not by way of limitation, in the figures accompanying the drawings, and in which like reference numerals refer to similar elements, and in which:

Figure 1A shows a cross-section of a typical storage node.
Figure 1B shows the semiconductor substrate of Figure 1A prior to forming a trench therein.
Figure 1C shows the semiconductor substrate of Figure 1B after forming a trench therein and filling the trench with polysilicon.
Figure 1D shows the semiconductor substrate of Figure 1C after planarizing an overlying blanket of polysilicon.

Figure 1E shows the semiconductor substrate of Figure 1B after forming a trench therein, lining the trench with a dielectric material, and filling the lined trench with polysilicon.

Figure 1F shows a recess formed in the trench of Figure 1E.

Figure 1G shows a recess above a column of polysilicon in a trench filled with a dielectric material.

Figure 1H shows the dielectric material of Figure 1G partly lining the trench of Figure 1G.

Figure 2 is a generalized schematic of a thin-film stack.

Figure 3A shows a transverse cross-section of a typical patterned substrate.

Figure 3B shows the patterned substrate of Figure 3A divided into two laterally-distinct areas or thin-film stacks.

Figure 3C shows a reflectance model for a layer interface.

Figure 3D shows a reflectance model for a single layer.

Figure 3E is a top view of the patterned substrate shown in Figure 3A.

Figure 4A shows a process setup according to an embodiment of an invention.

Figure 4B is an overview of a process for collecting normal incidence reflectance data according to one embodiment of the invention.

Figure 4C is an overview of a process for matching measured reflectance spectrum to modeled reflectance spectrum according to one embodiment of the invention.

Figure 4D is a schematic depicting a measured reflectance spectrum.

Figure 4E is a schematic depicting a modeled reflectance spectrum.

Figure 4F compares the measured reflectance shown in Figure 4D to the modeled reflectance spectrum shown in Figure 4E.

Figure 5A is an overview of a process for detecting an endpoint in a recess etch process according to one embodiment of the invention.

Figure 5B is a pre-etch model according to one embodiment of the invention.

Figure 6A is a pre-etch model according to another embodiment of the invention.

Figure 6B is an overview of a process for detecting an endpoint in a recess etch process according to another embodiment of the invention.

## DETAILED DESCRIPTION OF THE PREFERRED EMBODIMENTS

The invention will now be described in detail with reference to a few preferred embodiments, as illustrated in the accompanying drawings. In the following description, numerous specific details are set forth in order to provide a thorough understanding of the invention. It will be apparent, however, to one skilled in the art, that the invention may be practiced without some or all of these specific details. In other instances, well-known process steps and/or features have not been described in detail in order to not unnecessarily obscure the invention. The features and advantages of the invention may be better understood with reference to the drawings and discussions that follow.

The invention provides a robust and reliable method for determining an endpoint in a recess etch process. The method of the invention includes estimating in-situ incoming material variations. This estimation compensates for variations, such as differences in mask layer thicknesses, starting etch depths, and position and orientation of the substrate or differences in pattern density from one substrate to another. This allows the determination of the absolute vertical dimension of the column of material to be removed. A subsequent step includes using single- or multi-wavelength interferometry to monitor the actual etching of the recess. The interferometric endpoint detection method involves determining the number of fringes required to reach the desired recess depth. The number of fringes can be determined accurately once the absolute vertical dimension of the column of material to be removed and the starting etch depth are known.

In one embodiment, the invention uses broadband reflectometry to estimate the incoming material variations. In one embodiment, the method for estimating the incoming material variations involves measuring a reflectance spectrum of the semiconductor substrate. The physical parameters of interest are estimated by matching the measured reflectance spectrum to a modeled reflectance spectrum of the semiconductor substrate. In accordance with one embodiment of the invention, a model for calculating the reflectance spectrum of the semiconductor substrate is provided. Advantageously, the model does not place any restrictions on arrangement of features on the semiconductor substrate, *i.e.*, the model is not limited to a semiconductor substrate having special test features and can be applied to a semiconductor substrate having a complex array of random features.

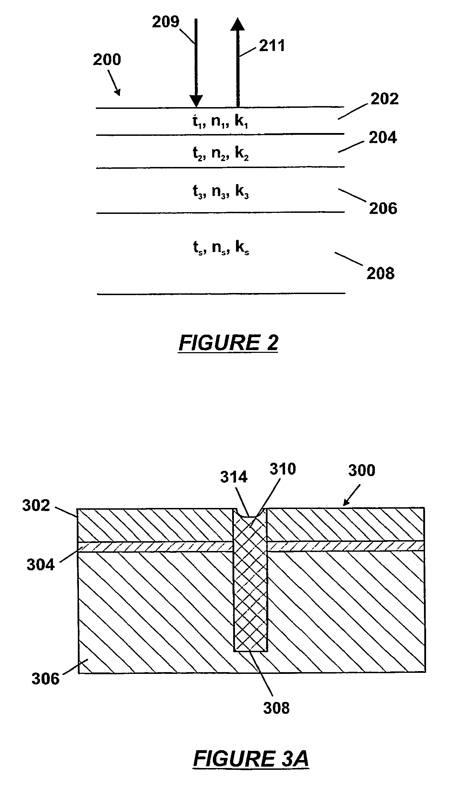

While not wishing to be bound by theory, the inventors believe herein that a patterned substrate can be divided into n laterally-distinct areas and that each distinct area can be modeled as an isotropic, homogeneous thin-film stack. For illustration purposes, Figure 2 shows a thin-film stack 200 having a stack of three-film layers 202, 204, 206 on a substrate layer 208. For example, the layer 202 could be made of polysilicon, the layer 204 could be made of silicon nitride, the layer 206 could be made of silicon dioxide, and the layer 208 could be made of silicon. Each of the layers 202, 204, 206, 208 has a thickness (t), a refractive index (n), and an extinction coefficient (k). Reflectance measurements are made by illuminating the thin-film stack 200 at normal incidence with a light beam 209 and collecting the light beam 211 reflected normally from the thin-film stack 200. For normal-incidence reflectometry, the response of an isotropic, homogeneous thin-film stack is polarization-independent. The inventors believe that the patterned substrate 200 can be assumed to have a nominally polarization-independent reflectance, which greatly simplifies the computational aspects of the model.

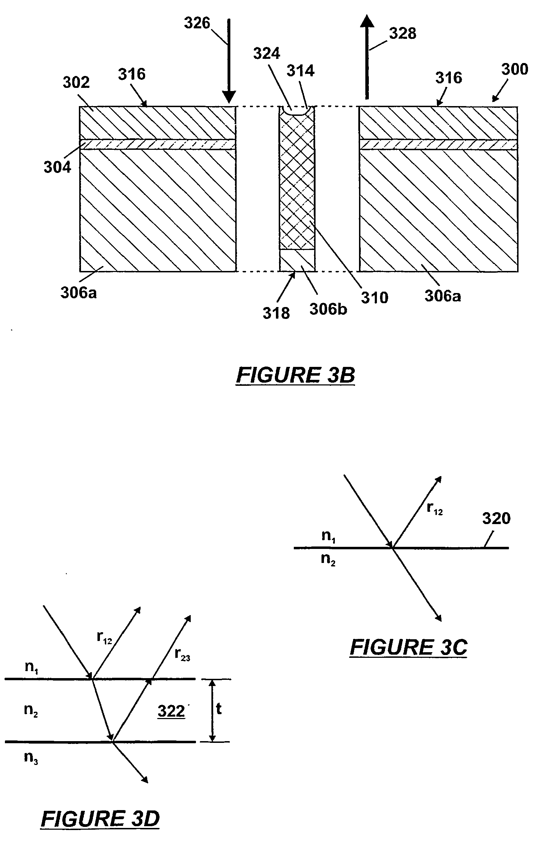

The main factors defining lateral distinctness are differences in layers constituting the thin-film stacks and differences in heights of the thin-film stacks. For illustration purposes, Figure 3A shows a transverse cross-section of a typical patterned substrate 300 having a mask layer 302, an oxide layer 304, and a substrate layer 306. A trench 308 is formed in the substrate 300 and filled with polysilicon 310. A small depression (or dish) 314 is formed at the top of the column of polysilicon 310 in the trench 308 as a consequence of the filling process and planarization processes. Figure 3B shows the patterned substrate 300 divided into two laterally-distinct areas or thin-film stacks 316, 318. The thin-film stack 316 includes the mask layer 302, the oxide layer 304, and a substrate layer portion 306a. The thin-film stack 318 includes the column of polysilicon 310 and a substrate layer portion 306b.

The reflectance of the patterned substrate 300 is a combination of the reflected fields from the thin-film stacks 316, 318. The reflected field for a given thin-film stack illuminated by a plane wave of known intensity and polarization can be calculated by setting up and solving a boundary problem or by using Fresnel equations. For example, using Fresnel equations, the reflectance at a layer interface (320 in Figure 3C) is given by:

$$r_{12} = \frac{n_1 - n_2}{n_1 + n_2} \tag{1}$$

The reflected field for a single layer (322 in Figure 3D) is given by:

$$r_{123} = \frac{r_{12} - r_{23} e^{i4\lambda_0 n_2 t}}{1 + r_{12} r_{23} e^{i4\lambda_0 n_2 t}} \tag{2}$$

Returning to Figure 3B, for the purposes of calculating net reflectance of the patterned substrate 300, the heights of the thin-film stacks 316, 318 should be the same. A layer of air or vacuum 324 is added to the top of the column of polysilicon 310 to compensate for the difference in the heights of the thin-film stacks 316, 318.

The inventors believe herein that given the wide distribution of the lateral extents of features constituting a typical patterned substrate, the reflected fields from the patterned substrate are likely to add coherently over some regions of the pattern and incoherently over some other regions of the pattern. The inventors believe that the relative contributions of the coherently and incoherently combined fields could vary as a function of free-space wavelength, $\lambda_0$, and do not necessarily correspond to the actual area fractions on the patterned substrate. Thus, once the reflected fields from each distinct thin-film stack have been calculated, the net reflectance from a patterned substrate can be calculated as a weighted incoherent sum of reflectances from n different regions constituting the pattern:

$$R = w_1(\lambda_0) |E_1|^2 + w_2(\lambda_0) |E_2|^2 + \cdots + w_n(\lambda_0) |E_n|^2 \tag{3}$$

where R is the net reflectance measured, $E_i$ are the individual incoherently adding field terms, and $w_i(\lambda_0)$ are the weighting factors for the incoherently adding terms. The use of $|E_i|^2$ denotes the magnitude of the complex field $E_i$ in the frequency domain notation of electromagnetic field theory.

Each individual incoherently adding term in equation (3) above could be the weighted, coherent sum of fields from k laterally-distinct areas constituting the $i^{th}$ region on the substrate:

$$E_i = \alpha_1(\lambda_0) E_{c1} + \alpha_2(\lambda_0) E_{c2} + \cdots + \alpha_k(\lambda_0) E_{ck} \tag{4}$$

where $\alpha_i(\lambda_0)$ are the weighting factors for coherently adding field terms $E_{ci}$. It should be noted that in equations (3) and (4), a "region" is not the same as a "distinct area."

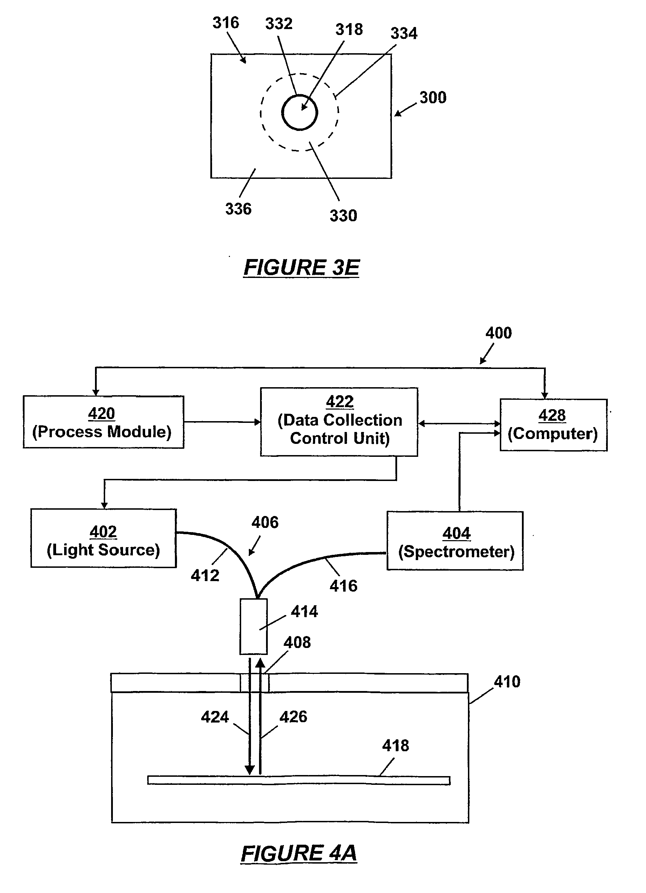

To further illustrate how the model above works, consider the patterned substrate 300 shown in Figure 3B. The patterned substrate 300 has been divided into two laterally-distinct areas or thin-film stacks 316, 318. In operation, an incident beam 326 strikes the patterned substrate 300 and is reflected, as shown at 328. Figure 3E shows a top view of the patterned substrate 300. Let $r_1$ represent the reflected field due to the thin-film stack 316 and $r_2$ represent the reflected field due to the thin-film stack 318. The inventors propose herein that there is a region 330 overlapping the boundary 332 between the thin-film stacks 316, 318, demarcated by imaginary line 334, where the reflection fields $r_1$ and $r_2$ would add coherently because of lateral interference effects. The reflectance from the region 336 outside of the imaginary line 334 is expected to be due to the reflected field from the thin-film stack 316 only.

From equation (3), the net reflectance from the patterned substrate 300 is:

$$R_{300} = w_{336}(\lambda_0)\,|\,E_{336}\,|^2 + w_{330}(\lambda_0)\,|\,E_{330}\,|^2 \qquad (5)$$

where $R_{300}$ is the net reflectance from the patterned substrate 300, $E_{330}$, $E_{336}$ are the individual incoherently adding field terms from the regions 330, 336, respectively, and $w_{330}(\lambda_0)$, $w_{336}(\lambda_0)$, are the weighting factors for the incoherently adding terms. From equation (4), $E_{330}$ is:

$$E_{330} = \alpha(\lambda_0)E_{336} + (1 - \alpha(\lambda_0))E_{318} \qquad (6)$$

It should be noted that $E_{336}$ is $r_1$, $E_{318}$ is $r_2$, and $w_{330}$ can be rewritten as $(1-w_{336})$. Thus, equation (6) can be rewritten as:

$$R_{300} = w_{336}(\lambda_0)\,|\,r_1\,|^2 + (1 - w_{336}(\lambda))\,|\,\alpha(\lambda_0)r_1 + (1 - \alpha(\lambda_0))r_2\,|^2 \qquad (7)$$

Equations (3) and (4) provide a simplified model wherein reflectance from a patterned substrate can be parameterized with respect to several quantities of interest, such as mask layer thickness and starting etch depth. In one embodiment, the invention uses normal incidence reflectometry as a technique for measuring reflectance, meaning the patterned substrate is illuminated by a beam incident normal to the substrate and only the light reflected normal to the substrate is collected, *i.e.,* only specularly reflected light is collected. However, because a range of orientations can be seen in any pattern, not all of the light striking the pattern will reflect at normal incidence. There will be non-specular reflection due to, for example, the depression (314 in Figure 3A). Reflection losses due to such non-specular reflection should not be ignored. In an embodiment of the invention, a scattering loss factor is applied to parts of the adding terms in equation (3) or to the entire reflectance in equation (3). The scattering loss factor could be a function of $\lambda_0$.

Figure 4A is a simplified schematic of a system 400 for estimating in-situ incoming material variations according to an embodiment of the invention. The system 400 includes a light source 402 for generating a light beam, a spectrometer 404 for detecting and analyzing a light beam, and an optical system 406 for transporting light to and from a port 408 at the top of a process chamber 410. For example, the optical system 406 could include an optical fiber 412 that transports light from the light source 402 to a collimator 414, where the collimator 414 is mounted above the port 408, and an optical fiber 416 that transports light from the collimator 414 to the spectrometer 404. A semiconductor substrate 418 is mounted inside the process chamber 410. To avoid obscuring the invention, the details of the processing equipment are not shown. However, it will be obvious to one of ordinary skill in the art what equipment is needed to perform the etching. For example, if the recess is to be formed via plasma etching, the substrate 418 would be mounted on a chuck (not shown) in the process chamber 410, and the appropriate equipment for generating the plasma would be provided.

In operation, a process module 420 that controls processing of the semiconductor substrate 418 sends a signal to a data collection unit 422 to trigger operation of the light source 402. When the light source 402 is triggered, it generates a light beam, which is transported through the optical fiber 412 to the collimator 414. The operating wavelength band of the light source 402 is selected to be in the region where sensitivity to the parameters of interest is heightened. Generally speaking, a broader range is more useful. In one example, the wavelength range of the light source is 190 to 1000 nm. The light beam 424 leaves the collimator 414, passes through the port 408, and strikes the substrate 418 at normal incidence. The collimator 414 collects the light beam 426 reflected normally from the substrate 418 at normal incidence. The reflected light beam 426 travels to the spectrometer 404 through the optical fiber 416. The spectrometer 404 analyzes the reflected light beam 426 and sends data representative of the reflectance spectrum of the substrate 418 to a computer 428 for further analysis.

The computer 428 includes a model for calculating reflectance of a patterned substrate, such as substrate 418, and a routine that searches for a set of parameterized parameters that provides an optimal match between the modeled reflectance spectrum and the measured reflectance spectrum received from the spectrometer 404. In one embodiment, the search routine is a non-linear regression routine. However, other types of search routines, such as multivariate regression analysis or neutral net matching, can also be used. A model for calculating reflectance of a patterned substrate has been described above. The set of parameters obtained can be mapped to several key quantities of interest, such as mask layer thickness and starting etch depth. The quantities of interest can then be used to determine an endpoint in the recess etch process, as will be further described below.

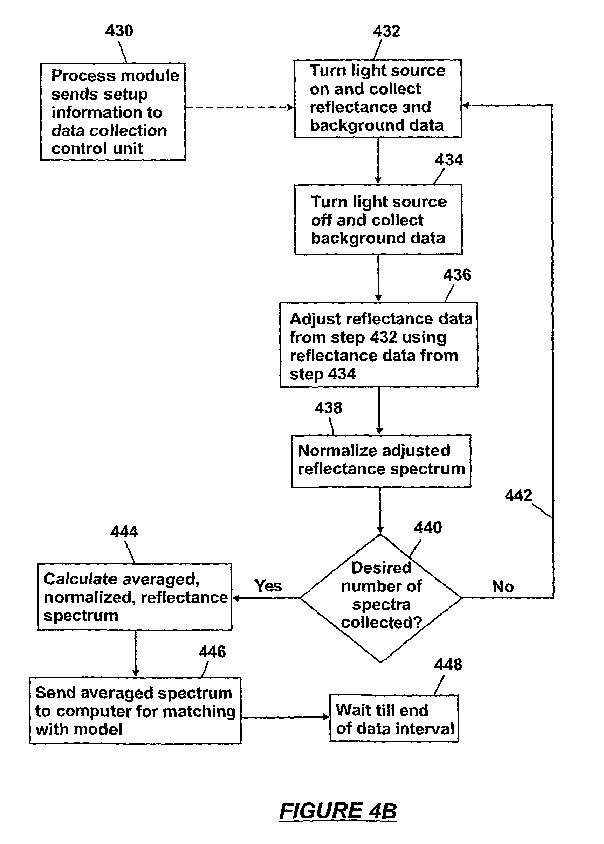

Figure 4B is an overview of a process for collecting normal reflectance data from a substrate according to an embodiment of the invention. One objective is to improve a high-quality reflectance signal even in the presence of significant background light levels such as the emission from a luminous plasma. At the start of the process, the process module (420 in Figure 4A) informs the data collection control unit (422 in Figure 4A) about how the reflectance data should be collected and calibrated (430). For example, the process module tells the data collection control unit the number of reflectance spectra and the length of time for which the spectra should be collected. The process module also gives the data collection control unit a baseline reflectance spectrum, typically a bare silicon reflectance spectrum, for calibration of the measured reflectance spectra. The bare silicon reflectance spectrum is collected prior to processing the substrate. When the data control collection control unit receives instruction to start collecting data, the light source (402 in Figure 4A) is turned on to generate a light beam, which is directed to strike the substrate, and the spectrometer (404 in Figure 4A) collects reflectance data from the substrate (432). Then, the light source is turned off and the reflectance data is collected again (434). When the light source is turned off, the data collected by the spectrometer is due to background sources, such as from plasma emissions, and detector noise. The next step is to subtract the reflectance data obtained in step 434 from the reflectance obtained in step 432 to remove the contribution of the background sources.

The corrected reflectance spectrum is normalized by a baseline spectrum (438). Then, the system checks if the desired number of reflectance spectra has been collected (440). If the desired number of reflectance spectra has not been collected, the system returns to step 432 and starts collecting data for another reflectance spectrum (442). If the desired number of reflectance spectra has been collected, the system computes an average of the collected reflectance spectra to obtain an averaged, normalized, reflectance spectrum (444). The averaged reflectance spectrum is sent to the computer (428 in Figure 4A) for matching with the model of the substrate (446). After sending the averaged reflectance spectrum to the computer, the system waits for the end of the specified length of time, after which it terminates (448).

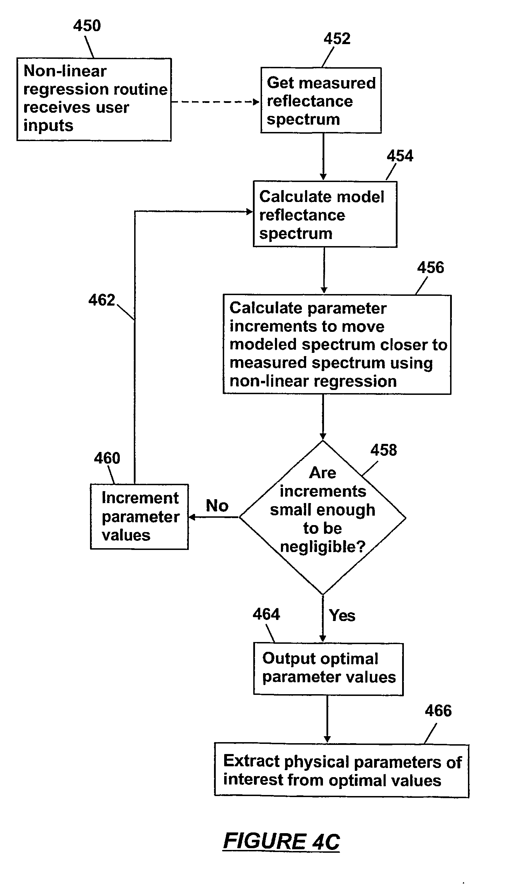

Figure 4C is an overview of a process for determining physical parameters of interest using a non-linear regression scheme. One objective is to quickly reach a converged set of parameter values by incrementally stepping the parameter values in the appropriate direction through the parameter space till the solution is reached. Prior to start of the non-linear regression analysis, the non-linear routine receives user inputs (450). The user inputs include initial guesses for a set of parameters to be determined by matching the reflectance spectrum to the modeled spectrum. The non-linear regression routine then obtains the averaged measured reflectance spectrum (452). Next, the modeled reflectance spectrum is calculated using equations (3) and (4) and the initial guesses (454). Then, the non-linear regression routine is used to calculate increments to the parameters in equations (3) and (4) to move closer to the best match between the measured reflectance spectrum and the modeled reflectance spectrum (456). The parameters in equations (3) and (4) are the reflected fields, the weighting factors w, and the coupling factors $\alpha$, which can be functions of the free-space wavelength, $\lambda_0$.

The system checks whether the increments calculated in step 456 are small enough to be negligible (458). If the increments are not small enough to be negligible, the system increments the values of the parameters (460) and returns to step 454 to recalculate the modeled reflectance spectrum using the new parameter values (462). If the increments are small enough to be negligible, the system outputs the optimal parameter values (464). The physical parameters of interest are then extracted from the optimal parameter values (466). Although not stated previously, the user inputs received in step 450 also include information about how to subdivide the substrate into laterally-distinct areas or thin-film stacks. The user inputs also include optical properties of each thin-film stack so that the reflected fields of each thin-film stack can be calculated, as previously described.

In one embodiment, the invention uses a modified version of a non-linear regression technique called the Levenberg-Marquardt Compromise to quickly and accurately locate optimal values of key parameter values starting from the initial guesses of the parameter values. Although, the Levenberg-Marquardt Compromise technique is a preferred technique, other techniques, such as multivariate regression analysis and neural net approaches, may also be employed to extract parameters of interest.

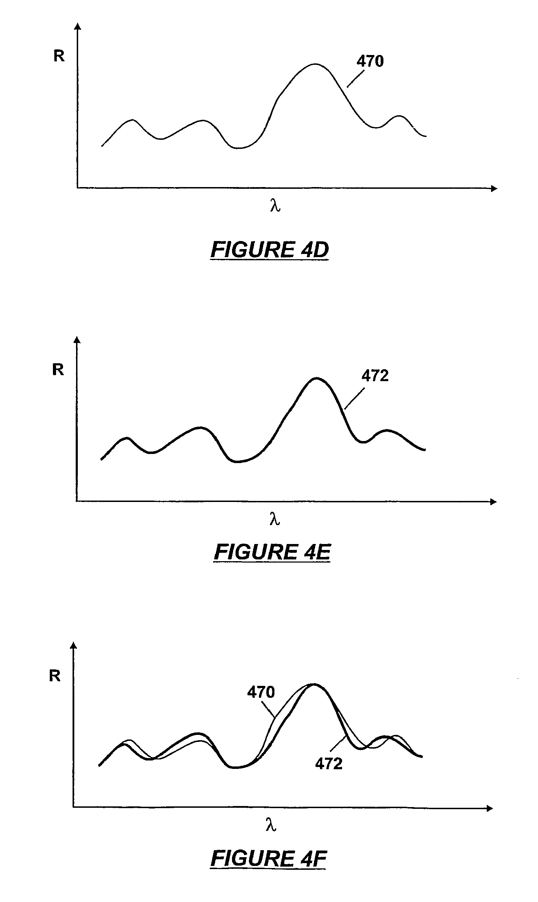

To illustrate how the non-linear regression works, Figure 4D shows a measured reflectance spectrum 470, and Figure 4E shows a modeled reflectance spectrum 472 computed using initial guesses from user inputs. The first step in the linear regression routine is to calculate a least squares difference error metric between the two reflectance spectra 470, 472. Figure 4F shows the measured reflectance spectrum 470 superimposed on the modeled reflectance spectrum 472. The least squares difference is computed by taking several points across the wavelength range, calculating the vertical difference between the spectra 470, 472 at each point, and summing the square of the differences at all the points. The least squares difference error metric is then used to determine the increments for the parameter values.

So far, the description of the non-linear regression analysis above is standard. Now, what happens in many cases is that a lot of the parameters that are not of interest cause significant changes in the entire modeled spectrum while the parameters of interest cause changes in small regions of the modeled spectrum. To allow the parameter values of interest to be located quickly and accurately, the differences in the regions of the spectrum where the parameters of interest are expected to make a difference are amplified by a factor, e.g., $(1 + \gamma_i)$, prior to summing the square of the differences at all the points. Thus, the least squares difference error is larger if the differences in the region of interest are larger. A constant or weighting factor may also be applied to the amplification factor to further bias the least squares difference error metric.

Figure 5A is an overview of a process for detecting an endpoint in a recess etch process according to an embodiment of the invention. The start of the process is triggered by a user (500). When the process starts, the process module (420 in Figure 4A) sends the appropriate process recipe parameters to all the sensors (502). The process recipe parameters could include, for example, the target recess depth relative to a reference point on the substrate, such as the bottom of a mask layer. The semiconductor substrate of interest is then transferred to the process chamber (410 in Figure 4A), or may already be in the process chamber (504). For illustration purposes, Figure 5B shows a pre-etch model 506 assumed in this process. The pre-etch model 506 includes a patterned semiconductor substrate 508 having a substrate layer 510. One or more layers, e.g., a mask layer 514 and an oxide layer 516, are formed on the substrate layer 510. A trench 518 is formed in the substrate 508 and filled with a column of polysilicon 520. In this model, all of a polysilicon layer (not shown) previously overlying the mask layer 514 has been planarized. However, this does not have to always be the case, *i.e.,* an amount of polysilicon may remain on the mask layer 514 prior to recess etching.

Returning to Figure 5A, after mounting the semiconductor substrate in the process chamber (410 in Figure 4A), gas flow into the process chamber is stabilized (522). A breakthrough process is then performed to remove any native oxide buildup on the semiconductor substrate as a result of exposing silicon to air (524). The breakthrough process can be a timed-etch process and should typically last for just a few seconds. It should be noted that the breakthrough process can result in loss of material from the top of the semiconductor substrate, which may need to be compensated for at a later stage. After the breakthrough process, gas flow into the process chamber is again stabilized (526). The next step is to estimate in-situ the incoming material variations (528). This step would include estimating thickness of one or more layers, such as a mask layer, as well as the starting etch depth, e.g., depth of depression above the column of polysilicon in the trench. This step could be executed during or after the stabilization step 526. Performing the estimation step 528 concurrently with the stabilization step 526 would save substrate processing time.

In the pre-etch model 506 shown in Figure 5B, the bottom 514a of the mask layer 514 is used as a reference point. It should be noted that other points on the substrate 508, e.g., the top of the substrate layer 510, can also be used as a reference point. The desired recess depth (D) measured from the reference point 514a would be a known quantity. The first vertical dimension of interest (H) would then be the vertical distance from the top 508a of the substrate 508 to the reference point 514a, which in this case corresponds to the thickness of the mask layer 514. The second vertical dimension of interest (d) would be the vertical distance from the top 508a of the substrate 508 to the top of the polysilicon column 520, *i.e.*, the depth of the depression 521 at the top of the polysilicon column 520. Once the dimensions H and d are known, the thickness of material (T) to be removed from the top of the polysilicon column 520 can be determined, *i.e.*, T = H + D - d. Returning to Figure 5A, the physical parameters of interest, e.g., H and d, can be estimated in step 528 using the broadband reflectometry method described above, *i.e.*, by determining a set of parameters that provide a close match between a measured reflectance spectrum of the substrate and a modeled reflectance spectrum of the substrate and extracting the desired dimensions from the set of parameters.

Once the thickness of material to be removed from the polysilicon column and the starting etch depth are known, the recess etch process can be started. Any suitable etching method, such as plasma etching, can be used to remove material from the polysilicon column. In one embodiment, an interferometric endpoint detection method is used to control the etching of the polysilicon column (530). The interferometric endpoint detection method involves counting the number of fringes evolved during the etch. When a predetermined number of fringes corresponding to the thickness of material to be removed has been counted, the recess etching process is stopped.

The interferometric approach involves directing a light beam to the polysilicon column. The light beam is partially reflected from the surface of the polysilicon column, partially transmitted through the polysilicon column, and reflected by the underlying substrate layer, as the polysilicon column is etched. The reflected signals combine constructively or destructively to produce a periodic interference fringe. The maxima and minima of the interference fringe depends on the path length of the light beam through the thickness of the polysilicon column being processed. During etching, the observed periodic maxima and minima of a measured interference fringe is correlated to a calculated reduction in the thickness of the polysilicon column to estimate an endpoint in the process. The interferometric approach can be used for monitoring the recess etch process because the absolute thickness of material to remove from the polysilicon column is known, *i.e.,* from the broadband reflectometry scheme described above.

Although an interferometric approach is discussed above as a preferred method for monitoring recess etching after accurately determining the initial thickness of the polysilicon column, it should be clear that other techniques may also be used. For example, the broadband reflectometry scheme described above can be used in-situ to determine the absolute thickness of the polysilicon as it is etched down to form the recess. This would involve continuously measuring a net reflectance of the substrate, finding a set of parameters that provide an optimal match between the measured net reflectance spectrum and a modeled reflectance spectrum of the substrate, and extracting the thickness of the polysilicon column from the set of parameters. When the desired thickness of the polysilicon column has been reached, the recess etch process can be stopped. A timed-etch process may also be used. That is, the time required to etch down a predetermined amount of material from the polysilicon column can be determined. The polysilicon column can then be etched for the predetermined time.

Various modifications can be made to the process sequence described in Figure 5A. For example, the process sequence in Figure 5A assumes a pre-etch model (506 in Figure 5B) wherein a polysilicon layer overlying, for example, a mask layer has already been planarized using, for example, a chemical-mechanical polishing process. In another embodiment of the invention, the process sequence may include a planarization step. For example, Figure 6A shows a pre-etch model 600 that includes a patterned semiconductor substrate 602 having a substrate layer 604. One or more layers, e.g., a mask layer 608 and an oxide layer 610, are formed on the substrate layer 604. A trench 614 is formed in the substrate 602 and filled with a column of polysilicon 616. A depression 618 is formed at the top of the column of polysilicon 616 as a consequence of the filling process. A layer of polysilicon 620 is also formed on the mask layer 608 during the filling process.

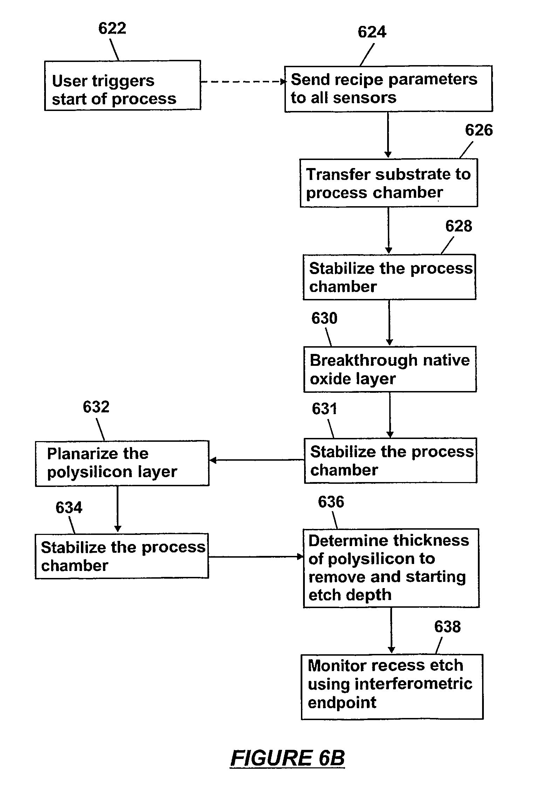

Figure 6B is an overview of a process for detecting an endpoint in a recess etch process assuming the pre-etch model (600 in Figure 6A). The start of the process is triggered by a user (622). When the process starts, the process module (420 in Figure 4) sends the appropriate process recipe parameters to all the sensors (624). The process recipe parameters could include, for example, the target recess depth measured from a reference point on the substrate, such as the bottom of the mask layer. The semiconductor substrate of interest is then transferred to the process chamber (410 in Figure 4), or may already be in the process chamber (626). After mounting the semiconductor substrate in the process chamber, gas flow into the process chamber is stabilized (628). A breakthrough process is then performed to remove any native oxide buildup on the semiconductor substrate as a result of exposing silicon to air (630). After the breakthrough process, gas flow into the process chamber is again stabilized (631). The layer of polysilicon (620 in Figure 6A) is then planarized using, for example, plasma etching (632). All or only a portion of the layer of polysilicon may be removed. If all of the polysilicon layer is removed, there may be some loss of material from the mask layer (608 in Figure 6A) underlying the polysilicon layer, which may need to be compensated for at a later stage. An interferometric approach or other suitable method can be used to determine when to end the planarization process.

After the planarization step, gas flow into the process chamber (410 in Figure 4) is again stabilized (634). The next step is to estimate in-situ incoming material variations (636), *i.e.,* estimate the vertical dimension from the top surface of the substrate to a reference point on the substrate, such as the bottom of the mask layer, and the vertical dimension from the top surface of the substrate to the top of the polysilicon column, i. e. , starting etch depth. This estimate will factor in any material loss as a result of the planarization and breakthrough processes. Estimation of the incoming material variations, *i.e.,* step 636, can be done concurrently with or after the stabilization step 634. In a manner similar to the one described above for step 528 in Figure 5A, the physical parameters of interest are determined in step 636. These physical parameters are then used to drive the recess etching process (638), in a manner similar to one described for step 530 in Figure 5A.

The invention provides one or more advantages. For example, the method of the invention can be used to detect an endpoint while forming a recess in a column of material in a trench. The method is applicable to any of the recess structures described in the background section as well as other recess structures not illustrated. Basically, the inventors recognize that there will be material variations from one substrate to another which will affect the thickness of material to remove from the column of material in the trench to achieve a desired recess depth. The general idea then is to determine the absolute thickness of material to remove prior to starting the etching process and then use this thickness to drive the etching process. The invention uses a broadband reflectometry method, including a robust model of the substrate and a biased non-linear regression technique, to accurately estimate the thickness of material to be removed via etching. With this accurate estimate, an interferometric approach, or other suitable method, can then be used to determine when to end the recess etch process.

While the invention has been described in terms of several preferred embodiments, there are alterations, permutations, and equivalents which fall within the scope of this invention. For example, the process sequences illustrated in Figures 5A and 6B are just examples based on the pre-etch models shown in Figures 5B and 6A, respectively. The process sequence will generally need to be adjusted based on the pre-etch state of the substrate and the desired recess structure. As previously mentioned, the basic idea is to get an accurate estimate of the thickness of material to be removed and the starting etch depth prior to etching. These parameters can then be used to drive the etching process.

Further, in estimating the incoming material variations, other techniques besides the Levenberg-Marquardt Compromise can be used to match the measured reflectance spectrum to the modeled reflectance spectrum of the substrate. For example, multivariate regression analysis and neural net match approaches can be used.

Further, monitoring of the recess etch process is not limited to an interferometric approach. A timed-etch process could be used, for example.

Further, the invention is not limited to making trench capacitors. For example, the invention can be used in monitoring recess etch processes used in forming chip interconnects.

What is intended therefore is that the following appended claims be interpreted as including all such alterations, permutations, and equivalents as fall within the scope of the invention.

## Claims

1. A method of controlling a recess etch process performed on a substrate, the substrate (508) including multiple layers (514, 516), the substrate having a trench (518) therein and a column of material deposited in the trench, the column of material (520) filling across a width of the trench up to a particular height, the method comprising:

   obtaining a measured net reflectance spectrum of at least a portion of the substrate including the trench;
   computing a modeled net reflectance spectrum of the portion of the substrate as a weighted incoherent sum of reflectances from $n \geq 2$ different regions constituting the portion of the substrate, the different regions having different optical reflection properties, the regions including at least a first region and a second region, the second region including at least the column of the material;
   adding at least one of an air layer and a vacuum layer to a top of the column of the material to compensate for a difference between heights of the first region and the second region;
   determining a set of parameters that provides a close match between the measured net reflectance spectrum and the modeled net reflectance spectrum; and
   extracting a value of a first dimension from the set of parameters, the first dimension representing a dimension from a surface of the substrate to a reference point in the substrate;
   computing the thickness of column material to be removed up to an endpoint of the recess etch process as a function of the first dimension, the air or vacuum layer difference between heights and a desired recess depth measured from the reference point; and
   etching down the column of material from a surface of the column of material until the endpoint is reached.

2. The method of claim 1, wherein obtaining the measured net reflectance spectrum comprises illuminating the portion of the substrate with a normal incident light beam.

3. The method of claim 1, wherein the reflectance of each of the n different regions is a weighted coherent sum of reflected fields from $k \geq 1$ laterally-distinct areas constituting the region.

4. The method of claim 3, wherein each laterally-distinct area is modeled as a thin-film stack.

5. The method of claim 4, wherein computing the modeled net reflectance spectrum comprises modeling the substrate as having a nominally polarization-independent reflectance.

6. The method of claim 1, wherein determining the set of parameters comprises calculating a least squares difference error metric between the measured net reflectance spectrum and the modeled net reflectance spectrum and finding the set of parameters that minimizes the error metric.

7. The method of claim 6, further comprising amplifying an effect of a change in the first dimension on the error metric.

8. The method of claim 7, wherein computing the modeled net reflectance spectrum comprises receiving as input a set of initial guesses for the set of parameters.

9. The method of claim 1, wherein the endpoint is based on a combination of broadband-reflectometry and an interferometric endpoint approach.

10. The method of claim 9, wherein computing the endpoint comprises computing a fringe count required to reach the endpoint.

11. The method of claim 10, wherein etching down comprises counting interference fringes evolved from the portion of the substrate during the etching and stopping the etching when the interference fringes evolved from the portion of the substrate have reached the fringe count

12. The method of claim 1, further comprising determining a second dimension from the surface of the substrate to the surface of the column of material.

13. The method of claim 12, wherein determining the second dimension comprises extracting the second dimension from the set of parameters.

14. The method of claim 13, wherein computing the endpoint further comprises adjusting the endpoint by an amount proportional to the second dimension.

15. The method of claim 1, further comprising planarizing the surface of the substrate prior to determining the first dimension.

16. The method of claim 1, further wherein the first region surrounds the second region.


**Patentansprüche**

1. Verfahren zum Steuern eines Vertiefungs-Ätzvorgangs, der an einem Substrat ausgeführt wird, wobei das Substrat (508) mehrere Schichten (514, 516) aufweist und in dem Substrat ein Graben (518) vorhanden ist und in den Graben eine Materialsäule eingebracht ist, wobei die Materialsäule (520) eine Breite des Grabens bis zu einer bestimmten Höhe ausfüllt,
wobei das Verfahren folgende Schritte aufweist:

   - Ermitteln eines gemessenen Netto-Reflexionsspektrums von mindestens einem den Graben beinhaltenden Bereich des Substrats;
   - Berechnen eines modellierten Netto-Reflexionsspektrums des Bereichs des Substrats als gewichtete inkohärente Summe von Reflexionen von $n \geq 2$ verschiedenen Regionen, die den Bereich des Substrats bilden, wobei die verschiedenen Regionen unterschiedliche optische Reflexionseigenschaften aufweisen und wobei die Regionen zumindest eine erste Region und eine zweite Region beinhalten, wobei die zweite Region zumindest die Materialsäule beinhaltet;
   - Addieren von mindestens einer von einer Luftschicht und einer Vakuumschicht an einer Oberseite der Materialsäule, um Höhenunterschiede zwischen der ersten Region und der zweiten Region zu kompensieren;
   - Bestimmen eines Satzes von Parametern, der eine enge Übereinstimmung zwischen dem gemessenen Netto-Reflexionsspektrum und dem modellierten Netto-Reflexionsspektrum erbringt; und
   - Extrahieren eines Werts einer ersten Dimension aus dem Satz von Parametern, wobei die erste Dimension eine Dimension von einer Oberfläche des Substrats bis zu einem Referenzpunkt in dem Substrat darstellt;
   - Berechnen der Dicke des Säulenmaterials, das bis zu einem Endpunkt des Vertiefungs-Ätzvorgangs zu entfernen ist, als Funktion der ersten Dimension, des Luftschicht- oder Vakuumschicht-Höhenunterschieds sowie einer ab dem Referenzpunkt gemessenen gewünschten Tiefe der Vertiefung; und
   - Abätzen der Materialsäule von einer Oberfläche der Materialsäule nach unten bis zum Erreichen des Endpunkts.

2. Verfahren nach Anspruch 1,
wobei das Ermitteln des gemessenen Netto-Reflexionsspektrums das Beleuchten des Bereichs des Substrats mit einem normalen einfallenden Lichtstrahl beinhaltet.

3. Verfahren nach Anspruch 1,
wobei es sich bei der Reflexion von jeder der n verschiedenen Regionen um eine gewichtete kohärente Summe von reflektierten Feldern von $k \geq 1$ lateral einzelnen Bereichen handelt, die die Region bilden.

4. Verfahren nach Anspruch 3,
wobei jeder lateral einzelne Bereich als Dünnschichtstapel modelliert wird.

5. Verfahren nach Anspruch 4,

wobei das Berechnen des modellierten Netto-Reflexionsspektrums ein derartiges Modellieren des Substrats beinhaltet, daß dieses eine nominal polarisationsunabhängige Reflexion aufweist.

6. Verfahren nach Anspruch 1,
wobei das Bestimmen des Satzes von Parametern das Berechnen einer Differenzfehlermetrik gemäß der Methode der kleinsten Quadrate zwischen dem gemessenen Netto-Reflexionsspektrum und dem modellierten Netto-Reflexionsspektrum sowie das Auffinden des Satzes von Parametern beinhaltet, der die Fehlermetrik minimiert.

7. Verfahren nach Anspruch 6,
bei dem weiterhin eine Verstärkung eines Effekts einer Änderung in der ersten Dimension an der Fehlermetrik erfolgt.

8. Verfahren nach Anspruch 7,
wobei das Berechnen des modellieren Netto-Reflexionsspektrums das Empfangen eine Satzes von anfänglichen Schätzungen für den Satz von Parametern als Eingabe beinhaltet.

9. Verfahren nach Anspruch 1,
wobei der Endpunkt auf einer Kombination eines Breitband-Reflektometrie- und eines interferometrischen Endpunkt-Ansatzes basiert.

10. Verfahren nach Anspruch 9,
wobei die Berechnung des Endpunktes die Berechnung eines Streifen-Zählwerts beinhaltet, der bis zum Erreichen des Endpunktes erforderlich ist.

11. Verfahren nach Anspruch 10,
wobei das Abätzen nach unten das Zählen von Interferenz-Streifen, die während des Ätzvorgangs aus dem Bereich des Substrats entstehen, sowie das Stoppen des Ätzvorgangs beinhaltet, wenn die aus dem Bereich des Substrats entstehenden Interferenz-Streifen den Streifen-Zählwert erreicht haben.

12. Verfahren nach Anspruch 1,
bei dem weiterhin eine zweite Dimension von der Oberfläche des Substrats bis zu der Oberfläche der Materialsäule bestimmt wird.

13. Verfahren nach Anspruch 12,
wobei das Bestimmen der zweiten Dimension das Extrahieren der zweiten Dimension aus dem Satz von Parametern beinhaltet.

14. Verfahren nach Anspruch 13,
wobei das Berechnen des Endpunktes ferner das Justieren des Endpunktes um einen Betrag proportional zu der zweiten Dimension beinhaltet.

15. Verfahren nach Anspruch 1,
das weiterhin das Einebnen der Oberfläche des Substrats vor der Bestimmung der ersten Dimension beinhaltet.

16. Verfahren nach Anspruch 1,
bei dem weiterhin die erste Region die zweite Region umgibt.

**Revendications**

1. Procédé de contrôle d'un processus de gravure :

réalisé sur un substrat, le substrat (208) comprenant de multiple couches (514, 516), le substrat présentant un sillon (518) et une colonne de matériau déposé dans le sillon, la colonne de matériau (520) remplissant une largeur du sillon jusqu'à une hauteur particulière, ce procédé comprenant :

l'obtention d'un spectre de facteur de réflexion net mesuré d'au moins une portion du substrat comprenant le sillon ; le calcul d'un spectre de facteur de réflexion net modélisé de la portion du substrat en tant que somme incohérente pondérée des facteurs de réflexion de n ≥ 2 régions différentes constituant la portion du substrat, ces différentes régions ayant des propriétés de réflexion optique différentes, ces régions comprenant au moins une première région et une seconde région, la seconde région comprenant au moins la colonne de matériau ;

l'ajout d'au moins une couche d'air ou une couche de vide en haut de la colonne de matériau afin de compenser la différence de hauteur entre la première région et la seconde région ;

la détermination d'un ensemble de paramètres permettant d'obtenir une correspondance étroite entre le spectre de facteur de réflexion net mesuré et le spectre de facteur de réflexion net modélisé ; et

l'extraction d'une valeur d'une première dimension à partir de l'ensemble de paramètres, la première dimension représentant une dimension entre une surface du substrat et un point de référence dans le substrat ;

le calcul de l'épaisseur de la colonne de matériau à enlever jusqu'à la fin du processus de gravure en fonction de la première dimension, de la différence entre les hauteurs de la couche d'air et de la couche de vide et une profondeur de gravure mesurée à partir du point de référence ; et

la gravure de la colonne de matériau à partir d'une surface de la colonne de matériau jusqu'à ce que le point final soit atteint.

**2.** Procédé de la revendication 1, dans lequel l'obtention du spectre de facteur de réflexion net mesuré comprend l'éclairage de la portion du substrat avec un faisceau lumineux à incidence normale.

**3.** Procédé de la revendication 1, dans lequel le facteur de réflexion de chacune des n régions différentes est une somme cohérente pondérée des champs réfléchis de $k \geq 1$ zones latéralement distinctes constituant la région.

**4.** Procédé de la revendication 3, dans lequel chaque zone latéralement distincte est modélisée comme une pile à film mince.

**5.** Procédé de la revendication 4, dans lequel le calcul du spectre de facteur de réflexion net modélisé comprend la modélisation du substrat comme possédant un facteur de réflexion nominal indépendant de la polarisation.

**6.** Procédé de la revendication 1, dans lequel la détermination de l'ensemble de paramètres comprend le calcul d'une métrique d'erreur à l'aide de la différence des moindres carrés entre le spectre de facteur de réflexion net mesuré et le spectre de facteur de réflexion net modélisé ainsi que la détermination de l'ensemble de paramètres qui minimise la métrique d'erreur.

**7.** Procédé de la revendication 6, comprenant en outre l'amplification de l'effet d'un changement de la première dimension sur la métrique d'erreur.

**8.** Procédé de la revendication 7, dans lequel le calcul du spectre de facteur de réflexion net modélisé comprend la réception à l'entrée d'un ensemble d'ébauches initiales pour l'ensemble de paramètres.

**9.** Procédé de la revendication 1, dans lequel le point final est déterminé sur la base d'une combinaison de réflectométrie à large bande et d'une approche interférométrique du point final.

**10.** Procédé de la revendication 9, dans lequel le calcul du point final comprend le calcul d'un comptage de franges nécessaires pour atteindre le point final.

**11.** Procédé de la revendication 10, dans lequel la gravure comprend le comptage de franges d'interférence révélées à partir de la portion du substrat pendant la gravure et l'arrêt de la gravure lorsque les franges d'interférence révélées à partir de la portion du substrat ont atteint le nombre de franges.

**12.** Procédé de la revendication 1, comprenant en outre la détermination de la seconde dimension de la surface du substrat à la surface de la colonne de matériau.

**13.** Procédé de la revendication 12, dans lequel la détermination de la seconde dimension comprend l'extraction de la seconde dimension à partir de l'ensemble de paramètres.

**14.** Procédé de la revendication 13, dans lequel le calcul du point final comprend en outre l'ajustement du point final avec une valeur proportionnelle à la seconde dimension.

**15.** Procédé de la revendication 1, comprenant en outre la planarisation de la surface du substrat avant la détermination de la première dimension.

16. Procédé de la revendication 1, dans lequel en outre la première région englobe la seconde région.

**FIGURE 1A**

**FIGURE 1B**

**FIGURE 1C**

**FIGURE 1D**

**FIGURE 1E**

**FIGURE 1F**

**FIGURE 1G**

**FIGURE 1H**

**200**

**209**

**211**

**202**

$t_1, n_1, k_1$

**204**

$t_2, n_2, k_2$

$t_3, n_3, k_3$

**206**

$t_s, n_s, k_s$

**208**

## FIGURE 2

**314** **310** **300**

**302**

**304**

**306**

**308**

## FIGURE 3A

**FIGURE 3B**

**FIGURE 3C**

**FIGURE 3D**

316  332  318  334

300

336  330

**FIGURE 3E**

400

| 420 (Process Module) | 422 (Data Collection Control Unit) | 428 (Computer) |

402 (Light Source)

406

412

404 (Spectrometer)

416

414

408

424  426

410

418

**FIGURE 4A**

430

Process module
sends setup
information to
data collection
control unit

432

Turn light source
on and collect
reflectance and
background data

434

Turn light source
off and collect
background data

436

Adjust reflectance data
from step 432 using
reflectance data from
step 434

438

Normalize adjusted
reflectance spectrum

442

444

Calculate averaged,
normalized, reflectance
spectrum

Yes

440

Desired
number of
spectra
collected?

No

446

Send averaged spectrum
to computer for matching
with model

448

Wait till end
of data interval

**FIGURE 4B**

**450**

Non-linear regression routine receives user inputs

**452**

Get measured reflectance spectrum

**454**

Calculate model reflectance spectrum

**456**

Calculate parameter increments to move modeled spectrum closer to measured spectrum using non-linear regression

**462**

**458**

Are increments small enough to be negligible?

**460**

Increment parameter values

No

**464**

Yes

**466**

Output optimal parameter values

Extract physical parameters of interest from optimal values

## FIGURE 4C

**FIGURE 4D**

**FIGURE 4E**

**FIGURE 4F**

**500**

**502**

| User triggers start of process | ----------→ | Send recipe parameters to all sensors |

**504**

Transfer substrate to process chamber

**522**

Stabilize the process chamber

**524**

Breakthrough native oxide layer

**526**

Stabilize the process chamber

**528**

Determine thickness of polysilicon to remove and starting etch depth

**530**

Monitor recess etch using interferometric endpoint

## FIGURE 5A

**FIGURE 5B**

**FIGURE 6A**

**622**

User triggers
start of process

- - - - - →

**624**

Send recipe parameters
to all sensors

**626**

Transfer substrate to
process chamber

**628**

Stabilize the process
chamber

**630**

Breakthrough native
oxide layer

**631**

Stabilize the process
chamber

**632**

Planarize the
polysilicon layer

**634**

Stabilize the process
chamber

**636**

Determine thickness
of polysilicon to
remove and starting
etch depth

**638**

Monitor recess etch
using interferometric
endpoint

## FIGURE 6B

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6275297 B

**Non-patent literature cited in the description**

- REAL-TIME ETCH-DEPTH MEASUREMENTS OF MEMS DEVICES. JOURNAL OF MICRO ELECTRO-MECHANICAL SYSTEMS. IEEE INC, April 2002, vol. 11, 111-117